(19) **Europäisches Patentamt**

**European Patent Office**

**Office européen des brevets**

(11) **EP 1 724 788 A1**

(12) **EUROPEAN PATENT APPLICATION**

(43) Date of publication:
**22.11.2006 Bulletin 2006/47**

(51) Int Cl.:
***G11C 29/00*** *(2006.01)*

(21) Application number: **05104183.8**

(22) Date of filing: **18.05.2005**

(84) Designated Contracting States:
**AT BE BG CH CY CZ DE DK EE ES FI FR GB GR HU IE IS IT LI LT LU MC NL PL PT RO SE SI SK TR**
Designated Extension States:
**AL BA HR LV MK YU**

(71) Applicant: **STMicroelectronics S.r.l.**
**20041 Agrate Brianza (Milano) (IT)**

(72) Inventors:
• **Griseta, Antonio**
**70042, Mola di Bari (BA) (IT)**

• **Mazzone, Angelo**
**70037, Ruvo di Puglia (BA) (IT)**
• **Penza, Luigi**
**20059, Vimercate (MI) (IT)**

(74) Representative: **Maccalli, Marco et al**
**Maccalli & Pezzoli S.r.l.,**
**Via Settembrini, 40**
**20124 Milano (IT)**

(54) **Improved built-in self-test method and system**

(57) A method for testing a memory device (100) comprising an arrangement of a plurality of memory elements (104) is proposed. The method comprises a step for defining a first and a second scanning sequences for scanning the memory elements and a step for defining at least one test datum ({XX}). The method further includes the performance of at least once a succession of operations including:
a) writing the test datum into the plurality of memory elements, accessing thereto according to the first scanning sequence;
b) accessing each memory element according to the first scanning sequence, reading a content thereof and comparing the read content to the test datum, and writing thereinto a complement of said test datum;
c) accessing each memory element according to the second scanning sequence, reading a content thereof and comparing the read content to the complement of the test datum, and writing thereinto said test datum;
d) accessing each memory element according to the second scanning sequence, reading a content thereof and comparing the read content to the test datum, writing thereinto said complement of the test datum, and reading again the content thereof and comparing the read content to the complement of the test datum.

FIG.3A

**(Cont. next page)**

## FIG.3B

| | | | |
|---|---|---|---|
| ADD(12) | ADD(13) | ADD(14) | ADD(15) |
| ADD(8) | ADD(9) | ADD(10) | ADD(11) |
| ADD(4) | ADD(5) | ADD(6) | ADD(7) |
| ADD(0) | ADD(1) | ADD(2) | ADD(3) |

102

**Description**

The present invention relates to the field of memory Integrated Circuits (ICs), and more specifically to SRAMs, particularly SRAMs embedded in complex ICs such as Systems On a Chip (SOC).

Memory ICs, and particularly embedded SRAMs, like whichever IC, also need to be tested in such a way to ensure full functionality and, when possible, to improve the yield of their manufacturing processes. In fact, each produced memory device may be affected by a plurality of defects due to unavoidable manufacturing drawbacks caused by the process tolerances.

The test of embedded SRAMs in SOC systems is object of continuous searches and investments, considering the high percentage of silicon area occupied by SRAMs in the entire electronic system. Nowadays, the increasing sizes of modern large-scale memories, and performances required in the field of memory cache subsystems, show the limits of the pre-existing approaches to test.

The best way known in the art for testing an embedded SRAM is given by the so called Built-In Self Test (BIST) solutions which make use of "general purpose" memory test algorithms. Such general purpose memory test algorithms are in position to detect a complete set of possible faults that may occur in an integrated circuit. A description of the faults that may affect a semiconductor memory can be found in A.J. Van de Goor, "Testing Semiconductors Memories - Theory and Practice", Wiley&Sons, Chichester, UK, 1991.

Nevertheless, considering the continuous need of increase in memory size and in memory access speed, the approach of implementing BIST circuits encompassing general purpose memory test algorithms is reaching the limits in terms of test time and efficiency due to the technological capabilities.

In fact, such general purpose memory test algorithms are on one hand able to cover a complete set of faults, but on the other hand demand for test times becoming longer and longer as a consequence of increased memories dimensions.

A widely diffused general purpose memory test algorithm is the so called "Marinescu B". The number of test operations performed by this algorithm for detecting all the possible faults that may occur in a memory device under test is given by:

$$N_{oper}^{MB} = 17 * N * N_d,$$

where N represents the number of memory words of the memory device under test, and $N_d$ is the number of different test patterns used during the test (the memory test algorithm is repeated per each pattern). According to this memory test algorithm, $N_d$ depends on the memory parallelism, i.e., depends on the number of data bits $N_{db}$ forming each memory word:

$$N_d = \log_2(N_{db}) + 1.$$

The set of faults covered by general purpose memory test algorithms is derived from exclusively theoretical fault models that do not take into account the real physical implementation of the specific memory device under test.

In view of the state of the art outlined in the foregoing, the Applicant has faced the problem of how to improve the known BIST solutions for testing memory ICs, particularly ICs embedding SRAMs.

According to an embodiment of the invention, a method for testing a memory device as set forth in claim 1 is provided.

The method for testing a memory device comprising an arrangement of a plurality of memory elements comprises a step for defining a first and a second scanning sequences for scanning the memory elements and a step for defining at least one test datum. The method further includes the performance of at least once a succession of operations including:

    a) writing the test datum into the plurality of memory elements, accessing thereto according to the first scanning sequence;

    b) accessing each memory element according to the first scanning sequence, reading a content thereof and comparing the read content to the test datum, and writing thereinto a complement of said test datum;

    c) accessing each memory element according to the second scanning sequence, reading a content thereof and comparing the read content to the complement of the test datum, and writing thereinto said test datum;

    d) accessing each memory element according to the second scanning sequence, reading a content thereof and comparing the read content to the test datum, writing thereinto said complement of the test datum, and reading again the content thereof and comparing the read content to the complement of the test datum.

Further features and advantages of the present invention will be made clear by the following detailed description of a preferred embodiment thereof, provided purely by way of a non-limitative example, with reference to the attached drawings, wherein:

Figure 1 schematically illustrates a functional block view of a memory device;
Figure 2 depicts a schematic flow chart illustrating the steps of a 8N algorithm;
Figures 3A and 3B illustrate two example of increasing and decreasing address sequences;
Figure 4 schematically illustrates a possible BIST system implementation of the 8N algorithm;
Figure 5 provides a functional block view of a Finite State Machine implementing the 8N algorithm;
Figure 6 illustrates a state diagram showing the functioning sequence of a timing circuit;
Figure 7A illustrates a circuital implementation of the timing circuit;
Figure 7B illustrates a time diagram showing the temporal evolutions of the timing circuit;
Figure 8 shows a state diagram illustrating the functioning of an address counter included in the Finite State Machine implementing the 8N algorithm;
Figure 9 illustrates an exemplary circuital implementation of the address counter; and
Figure 10 illustrates a state diagram describing the functioning of an algorithm block included in the Finite State Machine implementing the 8N algorithm.

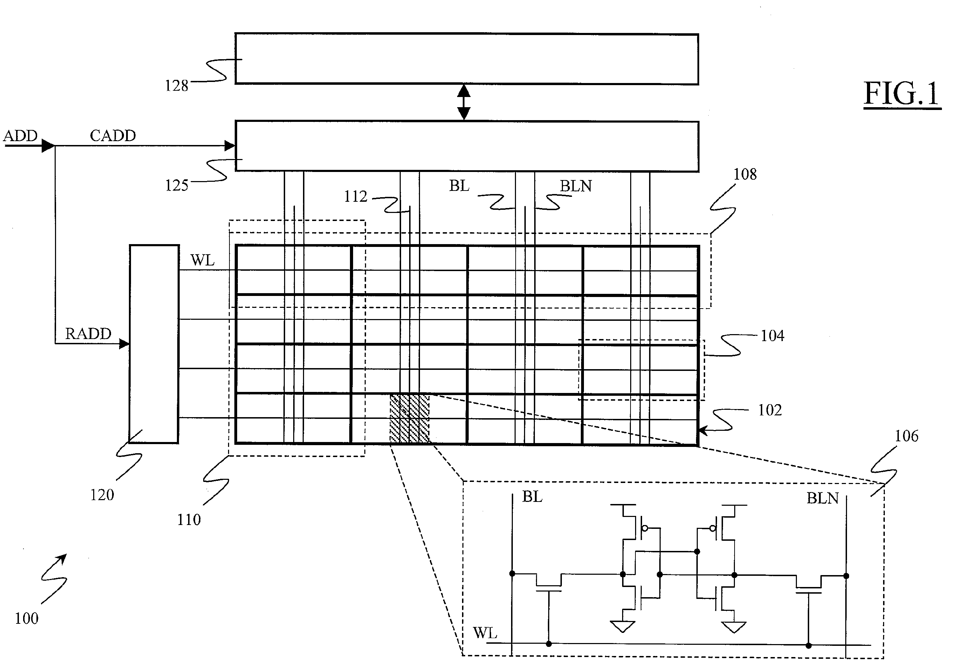

With reference to the drawings, in Figure 1 a SRAM memory device 100 is illustrated in terms of the main functional blocks.

The SRAM memory device 100 comprises a memory matrix 102 formed of a plurality of memory elements 104 in a two-dimensional arrangement of a plurality of rows 108 and of columns 110. More particularly, according to an embodiment of the present invention, the memory matrix 102 includes an even number (four in the example shown in the Figure) of rows 108, and a number of columns 110 that is a power of two ($2^2=4$ in the example shown in the Figure). The SRAM memory device 100 further includes a word line WL for each row 108 of the matrix, and a plurality (e.g., 8 or 16) of bit line pairs BL, BLN for each column 110 of the matrix, wherein every pair of bit lines corresponds to a respective SRAM memory cell 106, i.e., to one bit of a memory word (in the Figure, for the sake of clarity only one bit line pair per matrix column is depicted).

Each memory element 104 includes a plurality of SRAM cells 106 (for example, constituted by six MOS transistors, as shown in the enlarged detail of the Figure) belonging to the same row 108 of the memory matrix 102, in such a way to be able to store a memory word per memory element 104. It has to be noted that, in an embodiment of the present invention, the plurality of bit line pairs associated with the generic matrix column may include as few as just one bit line pair: this refers to the case wherein each memory element 104 includes a single SRAM memory cell 106, i.e., it refers to a SRAM memory device 100 with memory words constituted by only a single bit.

Still according to an embodiment of the present invention, the bit lines BL, BLN of each pair are paralleled with a corresponding shield line 112 extending inbetween them, and kept at a fixed voltage value, for example the ground voltage. In a possible practical implementation, the bit lines and the shield lines are formed in a conductive material like aluminum.

The SRAM device 100 further includes a row address decoder and row selection circuit 120, that allows selecting one word line WL among the others of the memory matrix 102, according to a row address RADD, that is a portion of a memory address ADD. Similarly, a column address decoder and column selection circuit 125 allows selecting a packet of, e.g., 8 or 16 of bit line pairs, corresponding to a single memory element 104, according to a column address CADD, which is a portion of the address ADD. Schematically shown as a block 128 are conventional circuits for sensing and writing the SRAM cells 106 of the memory matrix 102.

Thanks to the presence of the shield lines 112 and of design and layout constraints used for implementing the memory matrix, it is possible to reduce the effective set of faults that may affect the memory to a subset of the above-mentioned complete set of faults; in particular, the faults in the subset can be covered by a memory test method implementing an algorithm according to an embodiment of the invention, that will be described later on.

Such subset of faults refers to a fault model including the following faults (a more detailed description of the effective faults set will be provided later on) :

Stuck at Faults (SAF): Faults caused by circuital lines or nodes that result stuck at a logic value;
Coupling Faults (CF): Faults caused by coupling effects between circuital lines or nodes;
Address Faults (AF): Two or more addresses access a same memory word, or an address points to two or more memory words;
Transition Faults (TF): A memory cell can not make certain kinds of state transition (e.g., it cannot switch from a stored "0" to a stored "1", or vice versa);
Stuck Open Faults (SOF): A cell can not be accessed;
Unrestored Write Faults (UWF): Bit lines can not correctly recover to the right value after a write operation;
Data Retention Faults (DRF): Memory cells loose stored data after a while;
Write Through Faults (WTF): The state of input data affects reading operations.

The memory test algorithm according to an embodiment of the present invention, hereinafter also referred to as "8N algorithm", is described by the following pseudo-code:

| S1 | XX = 000...00 | |
|----|---------------|---|
| S2 | ⇑ Write{XX} | [M0] |
| S3 | ⇑ Read{XX} - Write{XX} | [M1] |
| S4 | ⇓ Read{XX} - Write{XX} | [M2] |
| S5 | ⇓ Read{XX} - Write{XX} - Read{XX} | [M3] |
| S6 | XX = 010...01 | |
| S7 | ⇑ Write{XX} | [M0] |
| S8 | ⇑ Read{XX} - Write{XX} | [M1] |
| S9 | ⇓ Read{XX} - Write{XX} | [M2] |
| S10 | ⇓ Read{XX} - Write{XX} - Read{XX} | [M3] |

The 8N algorithm comprises a series of ten steps (S1,S2,...S10). {XX} represents a binary data background word composed by a number of bits equal to the number of bits of the memory word stored in each memory element 104, while {XX} represents the complement thereof (e.g., if {XX}={000...00}, then {XX}={111...11}).

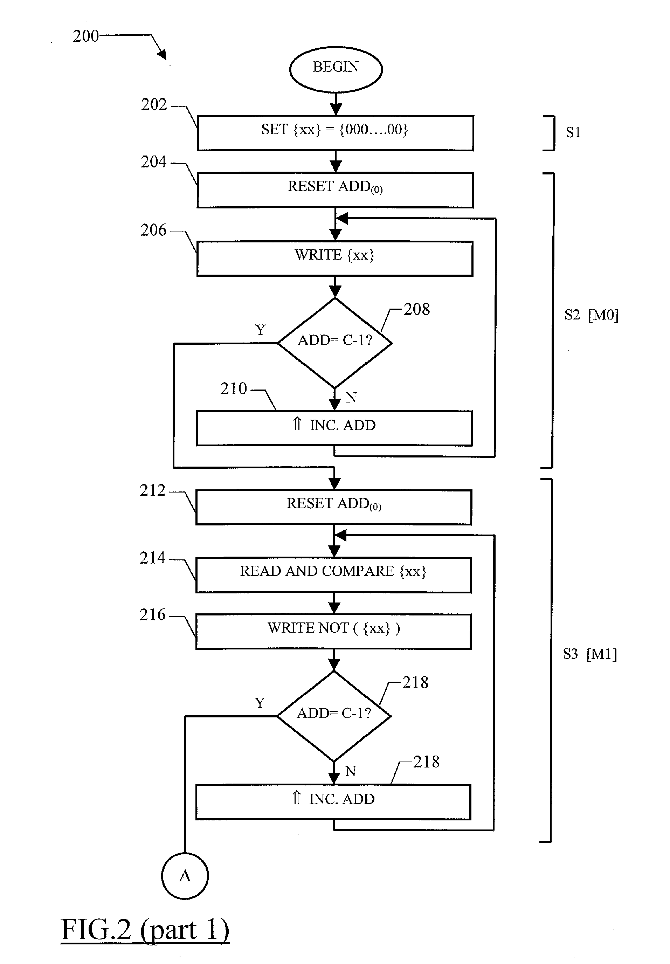

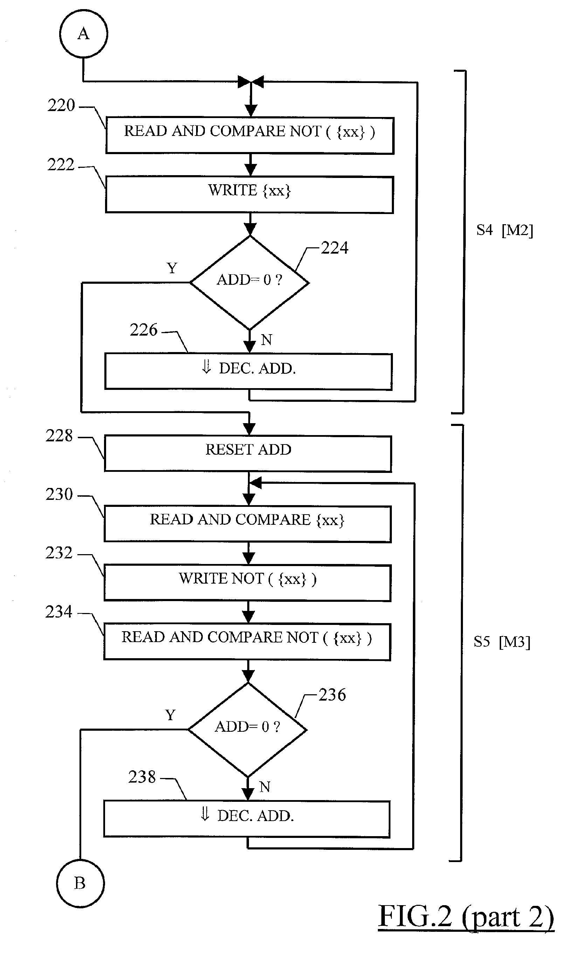

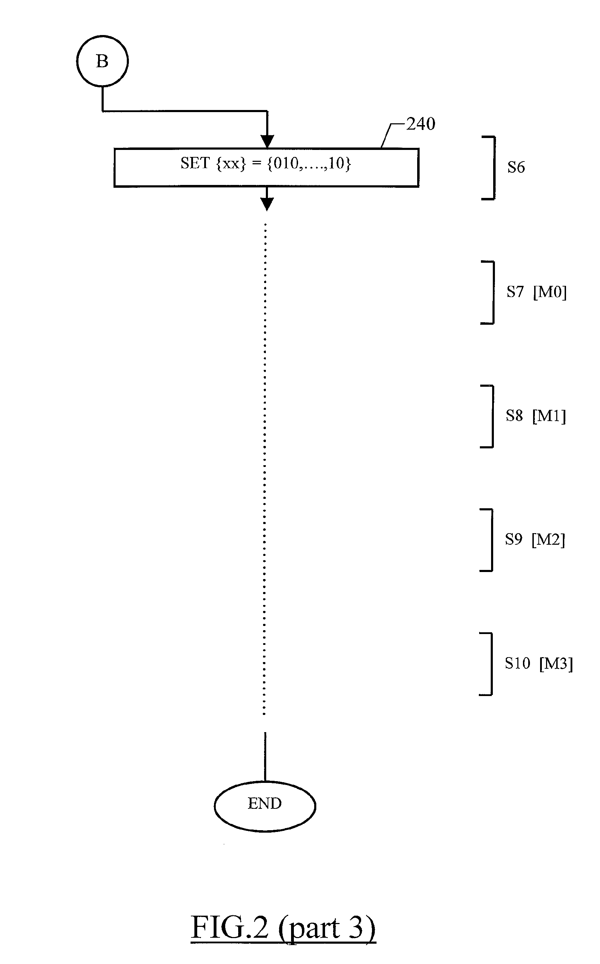

Figure 2 shows a flow chart diagram illustrating in more detail each step of the algorithm 8N.
At the step S1, the 8N algorithm sets the value of the data background word {XX} equal to {000...00} (block 202), in such a way that the operations Write{XX}, Read{XX} carried out in the steps S2, S3, S4, S5 are executed with data background words {XX} equal to {000...00}, and the operations Write{XX}, Read{XX} are executed with data background words {XX} equal to {111...11}.
The 8N algorithm includes four different types of "march elements" M0, M1, M2, M3. A march element is a finite sequence of one or more test operations that are to be performed on every memory element 104 in the memory matrix 102 before moving on to the next memory element. All the memory elements 104 of the memory matrix 102 are subjected to these same test operations and are traversed according to a particular address sequence. The 8N algorithm includes two different address sequences: an increasing address sequence, denoted in the pseudo-code by the symbol "⇑", and a decreasing address sequence, denoted in the pseudo-code by the symbol "⇓".
The increasing address sequence of the 8N algorithm in the case of a memory matrix having N addressable memory elements is (denoting the addresses ADD with their decimal value for the sake of simplicity):

⇑: (0), (N/2), (1), (N/2+1), (2), (N/2+2), (3), (N /2+3)..., while the decreasing address sequence is:
⇓: (N-1), (N/2-1), (N-2), (N/2-2), (N-3), (N/2-3), (N-4) ...

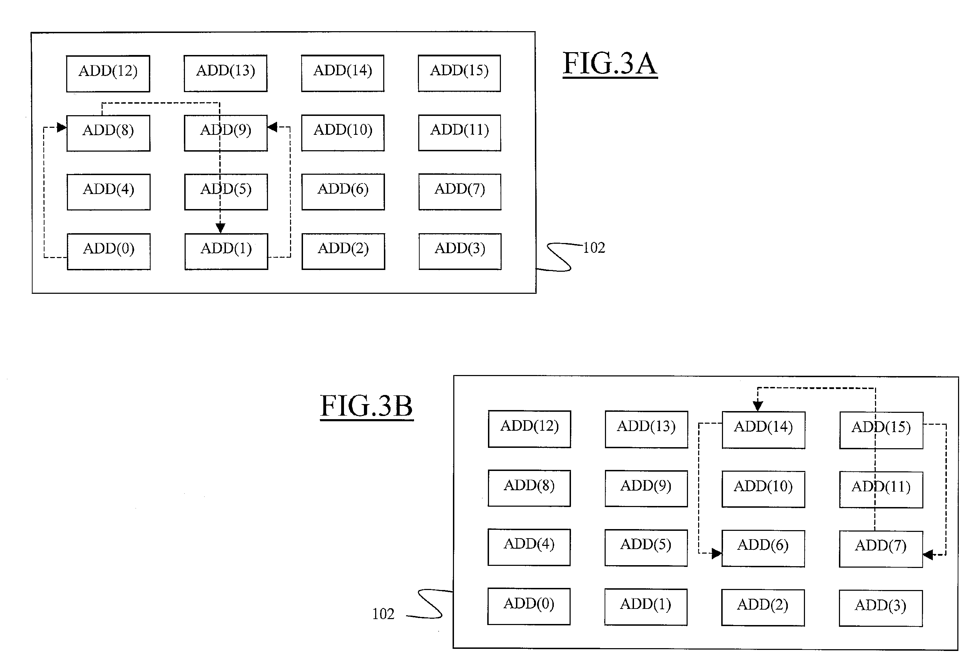

Using the aforementioned address sequences, it can be shown that both of the address sequences have the peculiarity of being constituted by the repetition of the following steps: two consecutives accesses to memory elements 104 belonging to the same column 110, followed by two consecutives accesses to memory elements 104 belonging to the same row 108.
Referring to Figure 3A, an example of increasing address sequence on the memory matrix 102 (having N=16 addressable memory elements 104) is shown. Denoting again the addresses ADD with their decimal value, the increasing address sequence is:

⇑: (0), (8), (1), (9), (2), (10), (3), (11)...

Referring now to Figure 3B, an example of decreasing address sequence on the same memory matrix 102 is shown. Denoting again the addresses ADD with their decimal value, the decreasing address sequence is:

⇓: (15), (7), (14), (6), (13), (5), (12), (4)...

At the step S2, the 8N algorithm starts the march element M0, initializing the address ADD to (0), i.e., to the address of the first memory element 104 (block 204). Successively, a writing operation Write{XX=000...00} is performed on such memory element 104 (block 206); then, if the address ADD is different from (N-1)(i.e., from the address ADD of the last memory element 104) (decision block 208, exit branch N), such address ADD is incremented of a step according to the increasing address sequence (block 210), and a writing operation Write{XX=000...00} is performed on the new addressed memory element 104 (the flowchart jumps back to the block 206). Conversely, if the address ADD is equal to (N-1) (decision block 208, exit branch Y), the 8N algorithm enters the step S3.

At the step S3, the 8N algorithm starts the march element M1, initializing the address ADD to (0) (block 212). Successively, the word stored in the memory element 104 having the address equal to ADD is read and is compared with the word {000...00} (reading operation Read{XX=000...00}, block 214), and then a writing operation Write{XX=111...11} is performed on the same memory element 104 (block 216). Consecutively, if the address ADD is different from (N-1) (block 218, exit branch N), such address ADD is incremented of a step according to the increasing address sequence (block 218), and the reading and comparing operations Read{XX=000...00 with the writing operation Write{XX=111...11} are performed on the new addressed memory element 104 (jump back to the block 214). Conversely, if the address ADD is equal to (N-1) (block 218, exit branch Y), the 8N algorithm enters in the step S4.

At the step S4, the 8N algorithm starts the march element M2. The word stored in the memory element 104 having the address equal to ADD is read and is compared with the word {111...11} (reading operation Read{XX=111...11}, block 220), and then a writing operation Write{XX=000...00} is performed on the same memory element 104 (block 222). Consecutively, if the address ADD is different from (0) (block 224, exit branch N), such address ADD is decremented of a step according to the decreasing address sequence (block 226), and the reading and comparing operations Read{XX=111...11} with the writing operation Write{XX=000...00} are performed on the new addressed memory element 104 (the flowchart jumps back to to the block 220). Conversely, if the address ADD is equal to (0) (block 224, exit branch Y), the 8N algorithm enters in the step S5.

At the step S5, the 8N algorithm starts the march element M3, initializing the address ADD to (N-1) (block 228). The word stored in the memory element 104 having the address equal to ADD is read and is compared with the word {000...00} (reading operation Read{XX=000...00 }, block 230), and a writing operation Write{XX=111...11} is performed on the same memory element 104 (block 232). Then, the word stored in the memory element 104 is read and is compared with the word {111...11} (reading operation Read{XX=111...11}, block 234). Consecutively, if the address ADD is different from (0) (block 236, exit branch N), such address ADD is decremented of a step according to the decreasing address sequence (block 238), and the reading and comparing operations Read{XX=000...00}, Read{XX=111...11} with the writing operation Write{XX=111...11} are performed on the new addressed memory element 104 (the flowchart jumps back to to the block 230). Conversely, if the address ADD is equal to (0)(block 224, exit branch Y), the 8N algorithm enters in the step S6.

At the step S6, the value of the data background word {XX} is set equal to {010...10} (block 202), in such a way that the operations Write{XX}, Read{XX} carried out in the steps S7, S8, S9, S10, are executed with data background words {XX} equal to {010...10}, and the operations Write{XX}, Read{XX} are executed with data background words {XX} equal to {101...01}. Being the steps S7, S8, S9, S10 identical to the steps S2, S3, S4, S5, except than in the data background word {XX} value, they will not be described in detail for the sake of conciseness.

Referring again to aforementioned pseudo-code implementing the 8N algorithm, it is possible to calculate the total number of operations $N^{8N}_{oper}$ executed for testing a memory matrix 102 having N addressable memory elements. During the steps S2, S3, S4, S5, the algorithm 8N executes the marches M0, M1, M2, M3, thus executing eight operations (four writing operations and four reading operations) per memory element 104. Moreover, during the steps S7, S8, S9, S10 the algorithm 8N executes again the marches M0, M1, M2, M3 with a different data background word ({XX}={010...10}), thus executing eight more operations. Consequently, the total number of operations $N^{8N}_{oper}$ executed by the 8N algorithm is:

$$N^{8N}_{oper} = 8*N*N_d = 8*N*2 = 16*N,$$

(the number of different test patterns used $N_d$ is equal to 2, regardless to the width of the word).

Therefore, compared to the known Marinescu B algorithm, which utilizes a very higher number of test operations $N^{MB}_{oper}$, the 8N algorithm is drastically less complex, while being equally efficient, as is discussed hereinbelow.

In the following there will be described with greater detail the subset of faults that the 8N algorithm can "cover", i.e., the faults that can be detected by such algorithm. Unless otherwise specified, in the following classical memory fault definitions are used, as stated by A.J. Van de Goor in the cited reference.

SAFs and TFs are covered since every SRAM cell 106 is read in both states, and after any possible state transition.

Concerning SOFs, a SRAM cell 106 is said to be "stuck-open" if it is inaccessible, e.g. because its word line WL or its bit lines connections are broken. A read operation on a stuck-open SRAM cell 106 produces unpredictable outputs. SOFs may also present a sequential behavior if a sense amplifier included in the block 128 is such that it holds data of a previous read operation. During the march element M3 all the SRAM cells are read successively in both states, so that SOFs with sequential behavior are detected. Furthermore, completely random outputs are statistically covered: since in M3 consecutive read operations of opposite polarity are executed when an address is incremented to the next one, the probability that the fault is masked because expected outputs are accidentally produced is virtually zero.

SRAM cells 106 can be affected by data losses, e.g. because a pull-up transistor is broken, thus causing a DRF. Such type of fault can be covered examining the dynamic behavior of each SRAM memory cell 106. Such dynamic behavior is detected by inserting two pauses (e.g., of 10 ms) before M2 and M3.

4 subtypes of AFs are defined (see A.J. Van de Goor, 3.4), which correspond to cases where two or more addresses ADD access the same memory element 104 or an address ADD points to two or more memory elements 104. All subtypes of such faults are covered in the 8N algorithm because in the march element M1, in combination with the march element M2, the condition that the following operations are included is satisfied (see A.J. Van de Goor, 3.5.2):

$\Uparrow$ Read{XX} ... - Write{$\underline{XX}$}
$\Downarrow$ Read{$\underline{XX}$} ... - Write{XX}

In SRAMs memories, AFs may cause one or more SRAM cells to become inaccessible (implying a SOF); in this case the full coverage of AFs requires that SOFs are also detected: as seen, the 8N algorithm can detect all SOFs and hence AF coverage is guaranteed.

Inter-word State Coupling Faults (SCFs) (i.e., coupling faults among different memory elements 104) are covered because, for every SRAM cell 106 pair belonging to different memory elements 104 and for each state of said cell pair, both cells are read. The following table illustrates for a generic pair of cells (a) and (b), which one is read first, and in correspondence of which march elements, as a function of the state of the pair (cell(a) address lower than cell(b) address):

| state (a) (b) | cell (a) | cell (b) |
|---|---|---|
| 0 0 | M1 | M3 |
| 0 1 | M3 | M3 |
| 1 0 | M2 | M1 |
| 1 1 | M3 | M2 |

Intra-word SCFs (i.e., coupling faults among SRAM cells 106 belonging to the same memory element 104) are conditionally covered. The two different data backgrounds {XX} used in the 8N algorithm cover only intra-word SCFs between bits of consecutive index (see A.J. Van de Goor, C.3).

Nonetheless, thanks to the design and layout constraints used for implementing the memory matrix 102, the 8N algorithm covers all realistic intra-word SCFs.

In particular, if each SRAM cell is physically separated from cells of the same word, no SCFs may occur.

Otherwise, if the above condition is unattainable due to topological constraints (e.g. no column multiplexing is provided), adjacent SRAM cells of the same word have consecutive indices, and so are intrinsically covered by using the two different data backgrounds {XX} employed in the 8N algorithm. Moreover, the data paths (i.e., read/write circuits and interconnects) of SRAM cells having non-consecutive indices are physically separated, and thus they do not imply SCFs.

A Linked SCF (LSCF) is an SCF involving more than two cells. Assuming that $N_{SCFL}$ is a number of coupling cells whose address is lower than the coupled cell, and $N_{SCFH}$ is a number of coupling cells whose address is higher than the coupled cell, it can be shown that an LSCF is equivalent to a single SCF if at least one of the following conditions is verified (Mikitjuk, V.G., Yarmolik, V.N., van de Goor, A.J.: "RAM Testing Algorithms for Detection Multiple Linked Faults", In Proc. Of the 1996 European Test Conference, Paris 1996.):

1. the result of a reading operation on the coupled cell is a deterministic function of all coupling states;
2. $N_{SCFL} = 1$ or $N_{SCFH} = 1$;
3. $N_{SCFL} > 1$, but all the coupling cells have the same effect on the coupled cell; and
4. $N_{SCFH} > 1$, but all the coupling cells have the same effect on the coupled cell

If none of the above conditions is verified, the LSCF cannot be detected by a march test. It is instead needed

a O($N^2$) algorithm; however, while an LSCF is possible, its probability of occurrence is extremely low, particularly considering that coupled cells on a LSCF are generally all the cells in a column 110.

Inversion Coupling Faults (Cins) are irrelevant to SRAMs field. Idem potent coupling effects (Cids) may affect SRAMs in the form of capacitive coupling between bit lines of SRAM cells 106 of the same row 108. If the capacitive coupling is large enough, the transition to "0" of a bit line in a cell may cause the transition to "0" of a bit line of a neighboring cell, and corrupt the cell content. This is especially true during write operations, in which one of the two bit lines in the cell being written is pulled down to ground.

Thanks to the abovementioned layout constraints, Cids are nullified by the memory design:

- bit lines in every cell are paralleled with shield lines 112 that shield them from the capacitive coupling of the adjacent columns; and
- in case of column multiplexing, the bit lines of non-addressed cells in a row 108 are clamped to Vdd (by precharge control circuits) throughout the read operations, thus providing a low-impedance path for the capacitive noise.

Most memory design solutions implement both solutions above. At least one solution is implemented in all designs. Therefore, Cids results automatically not relevant.

Furthermore, linked Cins or Cids (i.e., involving three or more SRAM cells) are even less relevant and will not be analyzed.

Dynamic Coupling faults (Cdyn), also known as "disturb fault", imply that reading operations may induce faults by transition or coupling. This kind of fault is irrelevant to SRAMs, because reading operations imply very low bit line voltage swings, whose energy is too low to cause a change in the state of the coupled cell. Like Cids, Cdyns are in any case made irrelevant by design.

The WTFs make the state of input data affect read operations. This type of fault may be caused by the presence of shorted write drivers. The 8N algorithm reads every SRAM memory cell in both states, when input data are at 0 and when they are at 1. This kind of test is possible also thanks to the inversion of memory cell input data during read operations in the march element M3. Consequently, WTF are covered.

Due to the possible presence of stuck-open transistors, combinatorial logic in the address decoders 120, 125 may exhibit a sequential behaviour. In this case, detecting the fault requires an initialisation sequence for each address (see A.J. Van de Goor, B.4). The 8N algorithm does not cover SOAFs. However, the statistical significance of SOAFs has been empirically proven by the Applicant to be very low on real designs.

If a defect in a precharge circuit of a column 110 makes bit lines very slow to recover their steady state (particularly after a write), a subsequent read of opposite polarity on the same column may fail because the corresponding sense amplifier is unbalanced, implying thus an UWF.

To detect UWFs, a generic test algorithm has to:

sweep the memory address space by columns;
run at the maximum memory operating speed;
for every column, read 0 after writing 1, read 1 after writing 0.

The 8N algorithm covers UWFs because M1 and M2 alternate read and write operations of opposite polarity with an address sequence that is by rows and columns, as previously explained.

It has to be noted that it is possible implementing the 8N algorithm using only a single data background word {XX} (thus, halving the number of test operations required) provided that the memory matrix 102 has a particular structure, such that SRAM cells 106 belonging to a same memory element 104 are physically separated from each other, and no capacitive coupling is possible. However, this layout restriction is generally very difficult to satisfy and its implementation requires a column multiplexing. The use of the two data background words {XX=000...00}, {XX=010...10} allows fully testing memories which not necessarily have such a particular matrix structure.

The 8N algorithm is an irredundant march memory test, since it contains the minimum required number of operations to cover all realistic faults. The number of operations required is fixed by the SCF's coverage, that is the fault type requiring the highest number of operations for the detection. In order to cover SCF faults at least eight reading operations are needed for each word.

In the following table there is shown the evolution of the state of a generic couple of SRAM cells $C_a$ and $C_b$ during the progress of the steps S2, S3, S4, S5 (that is, with data background word {XX} equal to {000...00}) of the 8N algorithm ("U" means "undefined"); the two SRAM cells $C_a$ and $C_b$ belong to different memory elements 104, and the address ADD of the cell $C_a$ is assumed to be lower than the address of the cell $C_b$:

| Operation on cell $C_a$ | Operation on cell $C_b$ | State $C_a$ | State $C_b$ | March Element |
|---|---|---|---|---|
| --- | --- | U | U | --- |
| Write{xx} | --- | {000...00} | U | M0 |
| --- | Write{xx} | {000...00} | {000...00} | M0 |
| Read{xx} | --- | {000...00} | {000...00} | M1 |
| Write{xx} | --- | {111...11} | {000...00} | M1 |
| --- | Read{xx} | {111...11} | {000...00} | M1 |
| --- | Write{xx} | {111...11} | {111...11} | M1 |
| --- | Read{xx} | {111...11} | {111...11} | M2 |
| --- | Write{xx} | {111...11} | {000...00} | M2 |
| Read{xx} | --- | {111...11} | {000...00} | M2 |
| Write{xx} | --- | {000...00} | {000...00} | M2 |
| --- | Read{xx} | {000...00} | {000...00} | M3 |
| --- | Write{xx} | {000...00} | {111...11} | M3 |
| --- | Read{xx} | {000...00} | {111...11} | M3 |
| Read{xx} | --- | {000...00} | {111...11} | M3 |
| Write{xx} | --- | {111...11} | {111...11} | M3 |
| Read{xx} | --- | {111...11} | {111...11} | M3 |

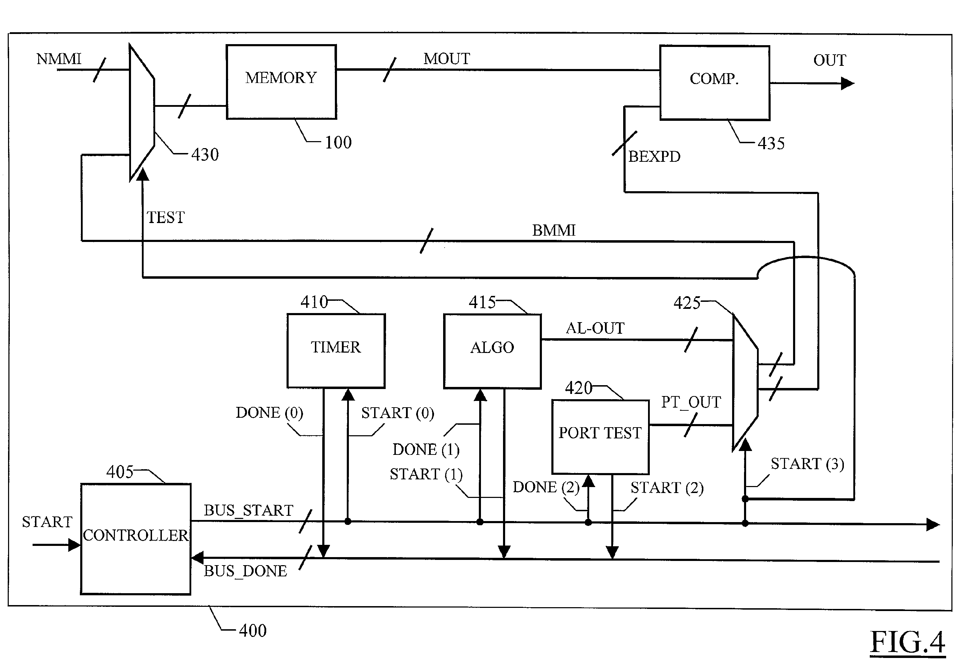

Referring now to Figure 4, a BIST system implementation of the 8N algorithm is illustrated. More particularly, an IC 400 including the memory device 100 comprises four Finite States Machines (FSMs) adapted to execute the 8N algorithm on the SRAM memory device 100. Furthermore, referring to Figure 4 and to the following Figures, for the sake of simplicity signals and corresponding physical lines carrying them are denoted with the same references.

A master controller FSM 405, whose purpose is to control three slave FSMs 410, 415, 420, is connected thereto by means of two buses of lines, namely, a first bus BUS_START and a second bus BUS_DONE. Each slave FSM receive an operation start signal, from the master controller FSM 405 by means of a predetermined line of the bus BUS_START, and provides an operation end signal to master controller FSM 405 by means of a predetermined line of the bus BUS_DONE. The operation start signal is asserted by the master FSM 405 to cause such slave FSM to start its operation; the slave FSM asserts the respective operation end signal when it has accomplished its duty. More particularly, a timer FSM 410, including counter circuits for the timing of the entire system, receives a signal START(0) from the bus BUS_START and provides a signal DONE(0) to the bus BUS_DONE. An 8N algorithm FSM 415, implementing the 8N algorithm, receives a signal START(1) from the bus BUS_START and provides a signal DONE(1) to the bus BUS_DONE. Finally, a port test FSM 420, implementing simple tests on the control ports of the memory device IC 400 (not shown in the Figure and not relevant for the understanding of the present invention), receives a signal START(2) from the bus BUS_START and provides a signal DONE(2) to the bus BUS_DONE. The memory device IC 400 further includes a multiplexer 425, receiving at its input terminals two buses AL_OUT, PT_OUT provided by the 8N algorithm FSM 415 and by the port test FSM 420, respectively. The multiplexer 425 selects one among said two buses AL_OUT, PT_OUT, by means of a control signal START(3) taken from the bus BUS_START, and provides two output buses BMMI and BEXPD. More particularly, a BIST mode memory input bus BMMI is provided to an input of a further multiplexer 430, while a BIST expected data bus BEXPD is provided to an input of a comparator block 435. The multiplexer 430 receives as a further input a normal mode memory input bus NMMI, and selects one among the two bus lines BMMI, NMMI by means of a test signal TEST, connecting it to the SRAM memory device 100 inputs. The SRAM memory device 100 provides a memory output bus MOUT to a further input of the comparator block 435. The comparator block 435 provides to the outside of the memory device IC 400 a signal OUT providing test result information.

The memory device IC 400 can operate in two different modes, that is, in test mode, and in standard operation mode.

During the standard functioning, the master controller FSM 405 is driven in such a way to deactivate the slave FSMs 410,415,420. The signal TEST is driven in such a way that the multiplexer 430 selects the normal mode memory input bus NMMI, providing data, commands and addresses, coming from outside the memory, to the SRAM memory device 100. In this way the SRAM memory device 100 is (possibly) utilized by a user or by another electronic device (possibly embedded in the same chip) for storing and/or reading information in its memory elements 104.

During the test functioning, triggered for example by the assertion of a signal denoted as START, the master controller FSM 405 activates the slave FSMs 410,415,420. Moreover, the signal TEST is driven in such a way that the multiplexer 430 selects the BIST mode memory input bus BMMI, which is composed by control lines providing control signals for controlling the memory device, e.g. providing a read/write command, a group of lines providing memory elements addresses, and a further group of lines providing data to be written in the SRAM memory device 100 for testing it; consequently, the SRAM memory device 100 executes such received commands on the memory elements 104 that are addressed. Successively, the results of the operations carried out by the SRAM memory device 100 in response of the commands received (i.e., the (expectedly) modified data contents of the addressed memory elements 104) are provided to an input of the comparator block 435 by means of the memory output bus MOUT. Moreover, the comparator block 435 further receives by means of the BIST expected data bus BEXPD expected data that are to be compared with the data provided by the SRAM memory device 100. If the SRAM memory device 100 has accomplished in a correct way the required operations on the addressed memory elements 104, the expected data coincide with the data provided by the SRAM memory device 100 itself, so the comparator block 435 signals, by means of the OUT signal, that the addressed memory elements 104 do not present faults. Conversely, if a fault occurs, the data provided by the SRAM memory device 100 do not coincide with the expected data, and the comparator block 435 signals it to the outside by means of the OUT signal.

All the data and the information necessary to execute the test on the SRAM memory device 100, that is, the data, the addresses and the commands provided by the two buses BMMI and BEXPD, can be generated either by the 8N algorithm FSM 415 (and made available by means of the bus AL_OUT), or by the port test FSM 420 (and made available by means of the bus PT_OUT), depending on the value taken by the signal START(3).

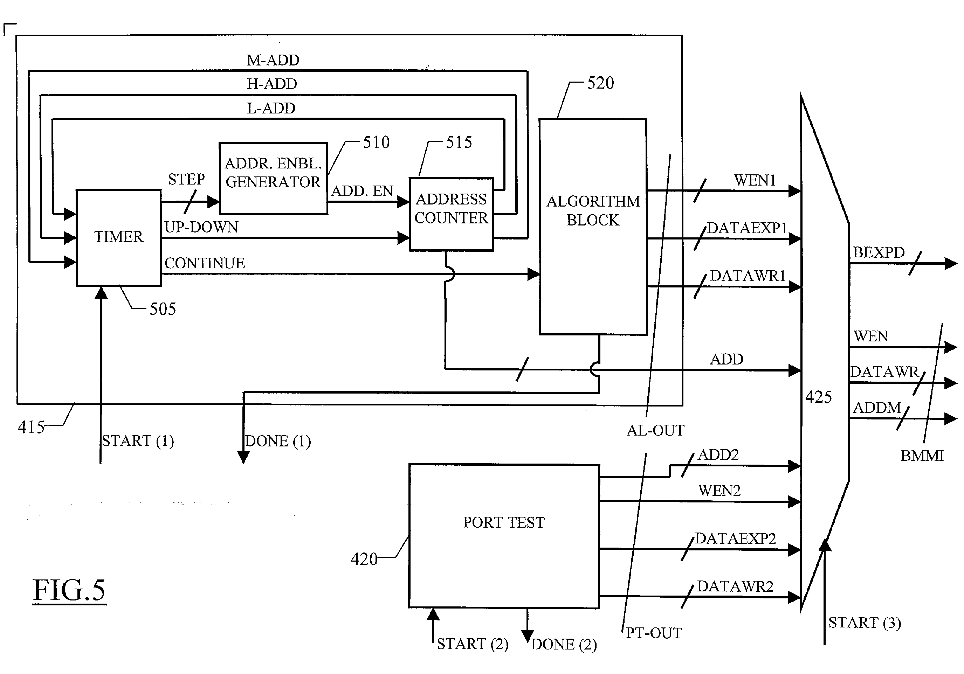

Figure 5 provides a more detailed view of the 8N algorithm FSM 415 (the specific structure and operation of the port test block is not relevant to the understanding of the invention embodiment herein considered).

The 8N algorithm FSM 415 includes a timer block 505, an address enable generator block 510, an address counter 515 and an algorithm block 520.

The timer block 505, whose purpose is the timing of the others circuital blocks included in the 8N algorithm FSM 415, receives the signal START(1) from the bus BUS_START, three signals L_ADD, M_ADD, H_ADD from the address counter 515 and provides a code STEP to the address enable generator 510, a signal UP_DOWN to the address counter 515, and a CONTINUE signal to the algorithm block 520.

The address enable generator 510 receives the code STEP from the timer block 505, and commands the address counter 515 by means of an address enable signal ADD_EN, as will be explained in the following.

The address counter 515, receiving the signal UP_DOWN and the signal ADD_EN, generates the address ADD, and the signals L_ADD, M_ADD, H_ADD. The algorithm block 520, that generates the commands and the data necessary for the test functioning according to the 8N algorithm, receives from the timer block 505 the signal CONTINUE. Said commands and data generated by the algorithm block 520 constitute, in concert with the address ADD, the bus AL_OUT that is provided to the multiplexer 425. More particularly, the algorithm block 520 generates a write enable signal WEN1, an expected data word DATAEXP1 and an input data word DATAWR1. The algorithm block 520 provides the signal DONE(1) to the bus BUS_DONE.

Furthermore, in the Figure 5 it is detailed also the bus PT_OUT, connecting the port test block 420 with the multiplexer 425: it includes an address bus ADD2, a line carrying a write enable signal WEN2, a bus carrying an expected data word DATAEXP2 and a further bus carrying an input data word DATAWR2. Finally, the BIST mode memory input bus BMMI is composed by an address bus ADDM, a line carrying a write enable signal WEN and a bus carrying an input data word DATAWR.

When the signal START(3) is driven in such a way to select the bus AL_OUT, the BIST expected data bus BEXPD receives the expected data word DATAEXP1, the address bus ADDM receives the address ADD, the input data word DATAWR assumes the value of the input data word DATAWR1, and the write enable signal WEN assumes the value of the write enable signal WEN1.

Conversely, when the signal START(3) is driven in such a way to select the bus PT_OUT, the BIST expected data bus BEXPD receives the expected data word DATAEXP2, the address bus ADDM receives the address ADD2, the input data word DATAWR assumes the value of the input data word DATAWR2, and the write enable signal WEN assumes the value of the write enable signal WEN2.

When the signal START(1) is driven to a high logic value, the 8N algorithm FSM 415 is activated by the timer block 505, that begins to generate the code STEP and the digital signals UP_DOWN, CONTINUE as a function of the digital signals L_ADD, M_ADD, H_ADD.

More particularly, STEP is a two bits code representing the "dimension" (i.e., the number of operations per word) of each march element MO...M3. For example, if the 8N algorithm FSM 415 is executing the march element M0, which includes a single operation (Write{XX}), the code STEP assumes the value "01". If the 8N algorithm FSM 415 is executing the march element M1 or the march element M2, including each one two operations (Read{XX} and Write{XX}, or Read{XX} and Write{XX}), the code STEP assumes the value "10". If the 8N algorithm FSM 415 is executing the march element M3, which includes three operations (Read{XX}, Write{XX} and Read{XX}), the code STEP assumes the value "11". Finally, if the 8N algorithm FSM 415 is in stand-by mode, that is, it is not executing any march element, the code STEP assumes the value "00".

The signal UP_DOWN provided to the address counter 515 is a one-bit signal whose logic value is necessary to discriminate the increasing address sequence (⇑) from the decreasing address sequence (⇓). For example, if the signal UP_DOWN is at the value "0", the address counter 515 generates addresses according to an increasing address sequence; conversely, if the signal UP_DOWN is at the value "1", the address counter 515 generates addresses following a decreasing address sequence.

The signal CONTINUE is a one-bit signal that is provided to the algorithm block 520 in such a way to signal thereto when a transition from a march element to the subsequent one occurs. For example, the signal CONTINUE assumes the value "1" in occurrence of said transitions, otherwise it assumes the value "0".

The code STEP and the digital signals UP_DOWN and CONTINUE are generated by the timer block 505 depending on the address ADD evolution, observable by counting occurrences of "1"s in the digital signals L_ADD, M_ADD, H_ADD provided by the address counter 515. Every time one among the signals L_ADD, M_ADD, H_ADD assumes a "1" value, an internal counter, not shown in the Figure, increments a counter value CNT. The signal L_ADD assumes a "1" value if the address ADD is equal to a predefined low value (in the example at issue, said low value corresponds to the lowest address (0)). The signal M_ADD assumes a "1" value if the address ADD is equal to a predefined intermediate value (in the example at issue, said intermediate value corresponds to the address (N/2)). The signal H_ADD assumes a "1" value if the address ADD is equal to a predefined high value (in the example at issue, said high value corresponds to the highest address (N-1)).

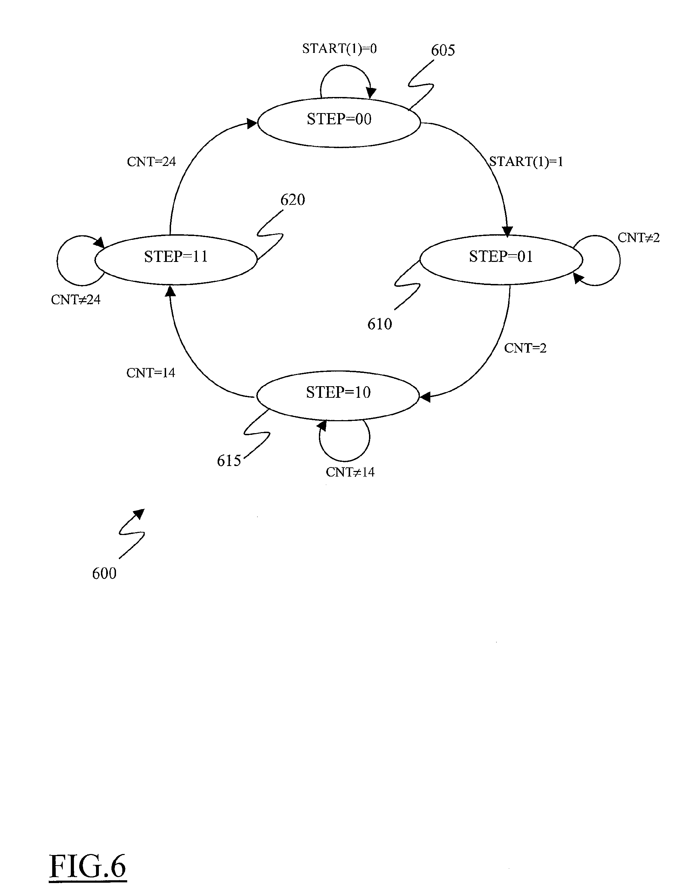

Referring to Figure 6, a state diagram 600 illustrating the generation sequence of the code STEP is shown. As long as the signal START(1) is at "0" value, the code STEP assumes the value "00" (block 605). When the signal START(1) assumes the "1" value, the code STEP assumes the value "01", and maintains it until the value of the counter value CNT is different from "2" (block 610). When the counter value CNT equals the value "2", the code STEP assumes the value "10", and maintains it until the value of the counter value CNT is different from "14" (block 615). When the counter value CNT equals the value "14", the code STEP assumes the value "11", and maintains it until the value of the counter value CNT is different from "24" (block 620). When the counter value CNT assumes the value "24" the address sequence is finished, and then the code STEP reassumes the value "00". The generation of the signals CONTINUE and UP_DOWN occurs in a similar way, and it is briefly explained by the two following tables:

| CNT | CONTINUE |
|------|----------|
| 7 | 1 |
| 14 | 1 |
| 0 | 1 |
| ELSE | 0 |

| CNT | UP_DOWN |
|------|---------|
| 2 | 1 |
| 8 | 1 |
| 14 | 1 |
| ELSE | 0 |

The address enable generator block 510 provides to the address counter 515 the address enable signal ADD_EN. The purpose of said address enable signal ADD_EN is to enable the address counter 515 to increment (or decrement, depending by the value of the signal UP_DOWN) the address ADD, according to the utilized address sequence. More particularly, the address counter 515 executes the increment (or the decrement) when the address enable signal ADD_EN assumes the value "1".

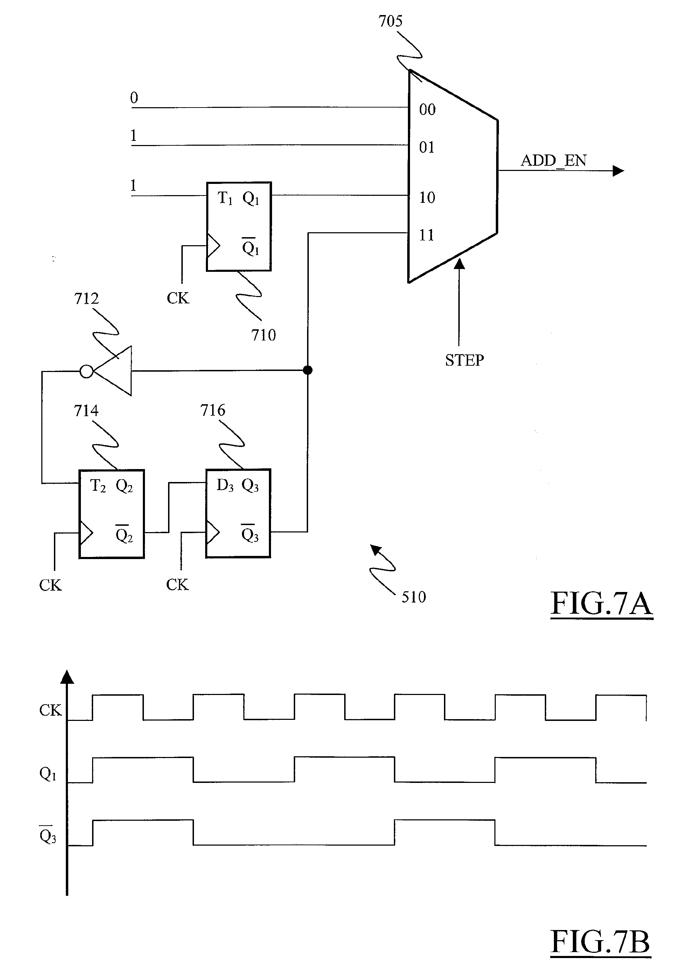

Given that the occurrence of these address increments depends from the number of operations within the different march elements MO...M3, the address enable generator 510 generates the address enable signal ADD_EN depending on the code STEP, for example exploiting the circuit structure shown in Figure 7A. The address enable generator 510 includes a multiplexer 705 having four input terminal, a control terminal receiving the code STEP, and an output terminal providing the address enable signal ADD_EN. The first input terminal, that is selected when the code STEP is equal to "00", is connected to a line stuck at "0". The second input terminal, that is selected when the code STEP is equal to "01", is connected to a line stuck at "1". The third input terminal, that is selected when the code STEP is equal to "10", is connected to an output terminal Q1 of a toggle flip-flop 710 whose input terminal T1 is stuck at "1" and its clock terminal receives a system clock signal CK. The fourth input terminal, that is selected when the code STEP is equal to "11", is connected to an input terminal of an inverter gate 712. An output terminal of the inverter gate 712 is connected to an input terminal T1 of a further toggle flip-flop 714, having a clock terminal receiving the system clock signal CK, and a complementary output terminal Qn2 connected to an input terminal D3 of a delay flip-flop 716. Said delay flip-flop 716 has a clock terminal receiving the system clock signal CK, and a complementary output terminal Qn3 connected to the input terminal of the inverter gate 712.

When the march element M0 is selected (STEP="01"), the address enable signal ADD_EN is stuck at the value "1", thus enabling the address counter 515 to increment (or decrement) the address ADD at every clock leading edge of the system clock signal clock. Referring to Figure 7B, wherein a time diagram illustrates the temporal evolutions of the system clock signal CK, of the output terminal Q1 and of the complementary output terminal Qn3, it can be noted that when the march element "M1" or "M2" is selected (STEP="10"), the address enable signal ADD_EN changes value at every clock leading edge. In this way, the address counter 515 is enabled to increment (or decrement) the address ADD every two clock leading edges of the system clock signal clock, thus allowing the execution of two consecutive operations on the same address ADD. Finally, when the march element "M3" is selected (STEP="11"), the address enable signal ADD_EN assumes the "1" value every three clock leading edges, thus allowing the execution of three consecutive operations on the same address ADD.

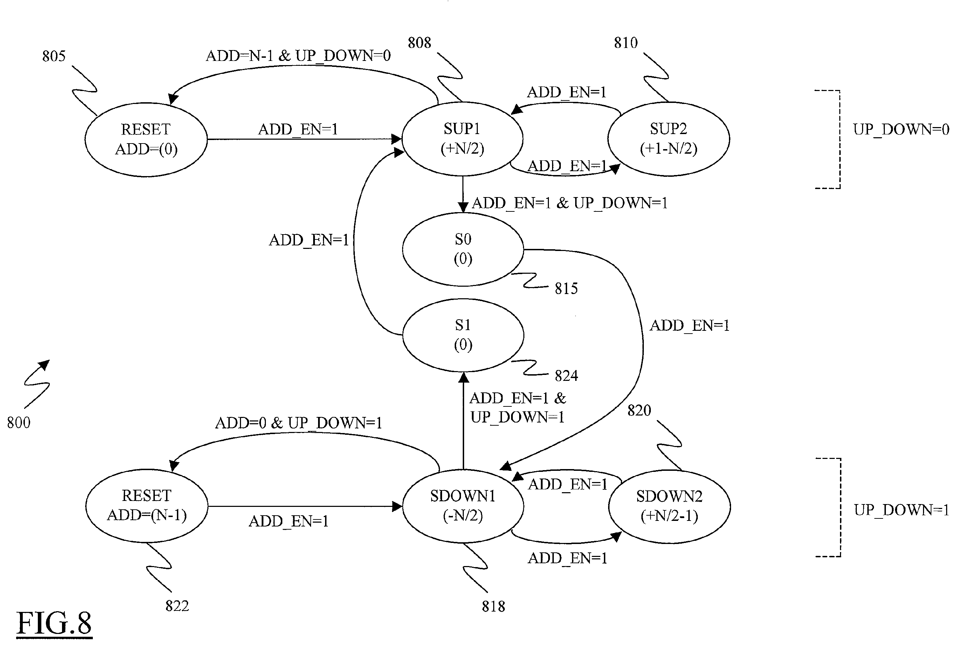

The address counter 515, receiving from the address enable generator block 510 the signal ADD_EN, and from the timer block 505 the signal UP_DOWN, generates accordingly the address ADD and the signals H_ADD, M_ADD and L_ADD. Referring to Figure 8, a state diagram 800 illustrating the functioning of the address counter 515 is shown. Since the 8N algorithm initiates with an increasing address sequence (signal UP_DOWN=0) that starts from the lowest address value (0), the address counter 515 sets the address ADD to (0) (block 805). When the signal ADD_EN assumes the value "1", the address counter 515 increments the address ADD by (N/2) (state SUP1, block 808). When the signal ADD_EN assumes again the value "1", the address counter 515 increments the previous address ADD by (1-N/2) (state SUP2, block 810). In correspondence of each successive occurrence of "1"s in the signal ADD_EN, the address counter 515 carries on an address increment on the address ADD, alternately by (N/2) (state SUP1, block 808) and (1-N/2) (state SUP2, block 810). This process continues until the address ADD assumes the highest value (N-1); in this way, the correct increasing address sequence (0),(N/2),(1),(N/2+1),(2),(N/2+2),(3), ..., (N-1) is generated. If, when the address ADD assumes the highest value (N-1), the signal UP_DOWN remains at the "0" value, the address counter 515 restarts an increasing address sequence, resetting the address ADD to (0) (block 805).

Conversely, if, when the address ADD assumes the highest value (N-1), the signal UP_DOWN assumes the "1" value, the address counter 515 starts a decreasing address sequence. Given that the first address of the decreasing address sequence is (N-1), i.e., it is equal to the last address of the previous increasing address sequence, the first time the signal ADD_EN assumes again the value "1", it is not necessary to execute any increment operation (state S0, block 815). In correspondence of a following "1" in the signal ADD_EN, the address counter 515 increments the address ADD by (-N/2) (state SDOWN1, block 818). When the signal ADD_EN assumes again the value "1", the address counter 515 increments the previous address ADD by (N/2-1) (state SDOWN2, block 820). In correspondence of each successive occurrence of "1"s in the signal ADD_EN, the address counter 515 carries on an address increment on the address ADD, alternately by (-N/2) (state SDOWN1, block 818) and (N/2-1) (state SDOWN2, block 820). This process continues until the address ADD assumes the lowest value (0); in this way, the correct decreasing address sequence (N-1), (N/2-1), (N-2), (N/2-2), (N-3), (N/2-3), ..., (0) is generated. If, when the address ADD assumes the lowest value (0) the signal UP_DOWN remains at the "1" value, the address counter 515 restarts a decreasing address sequence, firstly resetting the address ADD to the value (N-1) (block 822); then, in correspondence of a following "1" in the signal ADD_EN, the abovementioned sequence of increments by (-N/2) and (N/2-1) is repeated.

Conversely, if when the address ADD assumes the lowest value (0), the signal UP_DOWN assumes the "0" value, the address counter 515 starts a new increasing address sequence, necessary for repeating the test operations for a second time (e.g., when the data background word {XX} is changed). Given that the first address of the increasing address sequence is (0), i.e., it is equal to the last address of the previous decreasing address sequence, when the signals ADD_EN assumes again the value "1" for the first time, it is not necessary to execute any increment operation (state S1, block 824). In correspondence of a following "1" in the signal ADD_EN, the address counter 515 increments the address ADD by (N/2) (state SUP1, block 808), and so on.

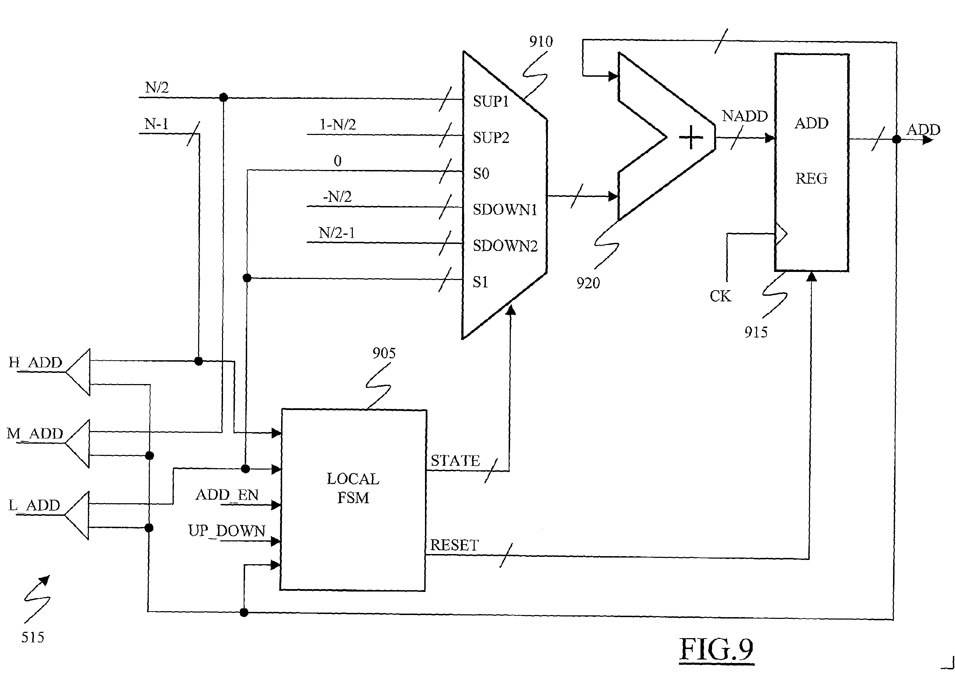

Referring now to Figure 9, an exemplary circuital implementation of the address counter 515 is shown. The address counter 515 includes a local FSM 905, whose purpose is to select a particular increment in such a way to generate the correct address sequence according to the values of the signals ADD_EN and UP_DOWN, as described previously. The local FSM 905 receives, in addition to the signals ADD_EN and UP_DOWN, the address ADD, a code (N-1) representing the binary value of the highest address value (N-1), and a code (0) representing the binary value of the lowest address value (0). Moreover, the local FSM 905 provides to the control terminal of a multiplexer 910 a code STATE, and to an address register 915 a code RESET. The possible values assumed by the code STATE correspond to the states SUP1, SUP2, SDOWN1, SDOWN2, S0, S1 mentioned above.

The multiplexer 910 receives at its input terminals six buses, each one carrying a fixed code word. More particularly, the first terminal receives a digital code (N/2) representing the binary value of the address (N/2), and is selected when the code STATE provided by the local FSM 905 is SUP1. The second terminal receives a digital code (1-N/2) representing the binary value of the address (1-N/2), and is selected when the code STATE provided by the local FSM 905 is SUP2. The third terminal receives the code (0), and is selected when the code STATE provided by the local FSM 905 is S0. The fourth terminal receives a digital code (-N/2) representing the binary value of the address (-N/2), and is selected when the code STATE provided by the local FSM 905 is SDOWN1. The fifth terminal receives a digital code (N/2-1) representing the binary value of the address (N/2-1), and is selected when the code STATE provided by the local FSM 905 is SDOWN2. Finally, the sixth terminal receives the code (0), and is selected when the code STATE provided by the local FSM 905 is S1. The multiplexer 910 further includes an output bus that is provided to an input of an adder block 920 required to execute the necessary address increment.

The address register 915 includes a clock terminal receiving the system clock signal CK, an input terminal receiving a code NADD provided by the adder block 920, an output terminal providing the address ADD, and a control terminal receiving the code RESET from the local FSM 905.

The adder block 920 comprises a first terminal receiving a code by the output terminal of the multiplexer 910, a second terminal receiving the address ADD, and an output terminal providing the code NADD.

The address counter 515 further includes three digital comparators 925, 930, 935 that generate the signals H_ADD, M_ADD and L_ADD exploited by the timer block 505. More particularly, the comparator 925 includes a first input terminal receiving the code (N-1), a second input terminal receiving the address ADD, and an output terminal providing the signal H_ADD. The comparator 930 includes a first input terminal receiving the code (N/2), a second input terminal receiving the address ADD, and an output terminal providing the signal M_ADD. The comparator 935 includes a first input terminal receiving the code (0), a second input terminal receiving the address ADD, and an output terminal providing the signal L_ADD.

The core of the address counter 515 is the local FSM 905. The code STATE assumed time by time by the local FSM 905 is used to select the corresponding increment according to the state diagram 800. Such selected increment is provided to the adder block 920, that adds it to an address ADD stored previously in the address register 915. The result of such operation, that is the code NADD, is then provided to the address register 915, replacing the previous address ADD. In this way, the sequence of values assumed by the address ADD follows the address sequence controlled by the local FSM 905. Moreover, the local FSM 905 can set the address ADD to (0) or to (N-1) by means of the code RESET, as requested by the functioning of the state diagram 800.

The signal H_ADD provided by the comparator 925 assumes the value "1" when the address ADD equals (N-1), the signal M_ADD provided by the comparator 930 assumes the value "1" when the address ADD equals (N/2), and the signal L_ADD provided by the comparator 935 assumes the value "1" when the address ADD equals (0), otherwise, they assumes the value "0".

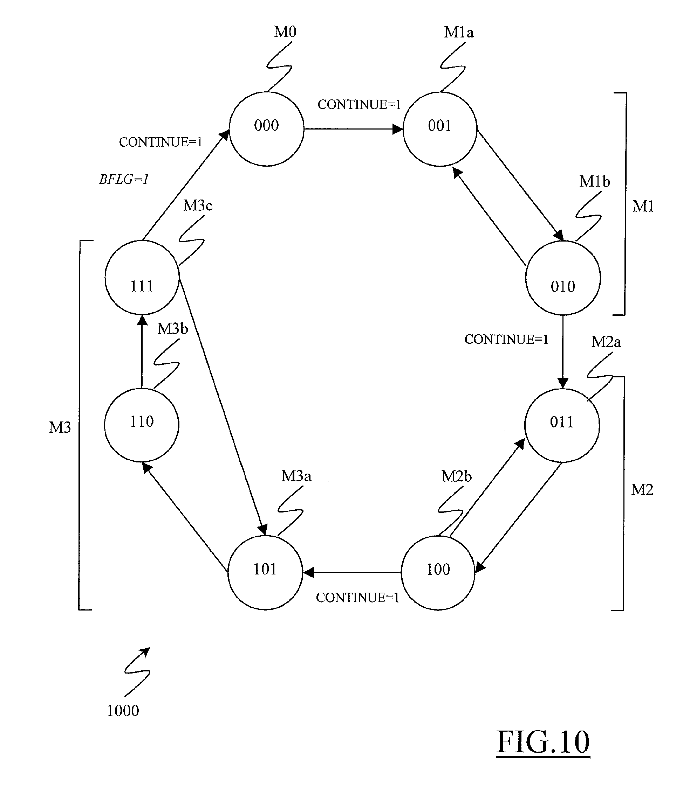

The algorithm block 520, receiving from the timer block 505 the signal CONTINUE, generates accordingly the write enable signal WEN1, the expected data word DATAEXP1, and the input data word DATAWR1. Referring now to Figure 10, a state diagram 1000 describing the functioning of such algorithm block 520 is illustrated. The algorithm block 520 includes a FSM machine with a dedicated state for each operation carried out in the 8N algorithm. Consequently, the state diagram 1000 includes eight different states, one state per operation. Furthermore, the evolution of the signal CONTINUE (i.e., its "1"s occurrences) scans the transitions among the different march elements M0,..., M3.

Initially, the algorithm block 520 commands the operation Write{XX=000...00} (state 000, block M0), as stated by the march element M0. When the signal CONTINUE assumes the value "1", the algorithm block 520 commands the operation Read{XX} (state 001, block M1a), and then commands the operation Write{XX} (state 010, block M1b). Subsequently, the algorithm block 520 repeats these two operations until the signal CONTINUE assumes again the value "1". These cyclic state transitions are due to the internal temporization of the algorithm block 520. In this way, all the operations included in the march element M1 are carried out. When the signal CONTINUE assumes again the value "1", the algorithm block 520 commands the operation Read{XX} (state 011, block M2a), and then it commands the operation Write{XX} (state 100, block M2b). Subsequently, the algorithm block 520 repeats these two operations until the signal CONTINUE assumes again the value "1". In this way, all the operations included in the march element M2 are carried out. When the signal CONTINUE assumes again the value "1", the algorithm block 520 commands the operation Read{XX} (state 101, block M3a), then it commands the operation Write{XX} (state 110, block M3b), and then it commands the operation Read{XX} (state 111, block M3c). Subsequently, the algorithm block 520 repeats these three operations until the signal CONTINUE assumes again the value "1". In this way, all the operations included in the march element M3 are carried out. When the signal CONTINUE assumes again the value "1", a background flag BFLG assumes a value "1", indicating that the subsequent operations are to be executed with the other data background word (i.e., {XX} ={010...10}). Thus, the algorithm block 520 commands the operation Write{XX=010...10} (return to the state 000, block M0), and then it repeats all the other operations.

In the following, a table illustrating the evolution of the algorithm block 520 FSM machine is shown.

| | | state | | | |
|---|---|---|---|---|---|
| **block** | **operation** | **S(2)** | **S(1)** | **S(0)** | **March Element** |
| M0 | Write{XX} | 0 | 0 | 0 | M0 |
| M1a | Read{XX} | 0 | 0 | 1 | M1 |
| M1b | Write{XX} | 0 | 1 | 0 | |
| M2a | Read{XX} | 0 | 1 | 1 | M2 |
| M2b | Write{XX} | 1 | 0 | 0 | |
| M3a | Read{XX} | 1 | 0 | 1 | M3 |
| M3b | Write{XX} | 1 | 1 | 0 | |
| M3c | Read{XX} | 1 | 1 | 1 | |

where S(2), S(1) and S(0) are the three state bits denoting the different states of the state diagram 1000.

Referring again to the state diagram 1000 and to the previous table, it has to be noted that each state is codified in such a way to allow obtaining output signals from the state bits. Specifically, the state bit S(0) corresponds to the write enable signal WEN1 (WEN1=0 corresponds to a writing operation, WEN1=1 corresponds to a reading operation).

The state bit S(1) determines the expected data word DATAEXP1. More particularly, the expected data word DATAEXP1 is equal to:

- {000...00} if the state bit S(1) is equal to "0" and the background flag BFLG is equal to "0";
- {111...11} if the state bit S(1) is equal to "1" and the background flag BFLG is equal to "0";
- {010...10} if the state bit S(1) is equal to "0" and the background flag BFLG is equal to "1"; and
- {101...01} if the state bit S(1) is equal to "1" and the background flag BFLG is equal to "1".

Furthermore, the input data word DATAWR1 to be written into the memory element 104 is calculated by means of all the three state bits S(2), S(1), S(0), and by means of the background flag BFLG, as is shown in the next table.

| **DATAWR1** | **S(2)** | **S(1)** | **S(0)** | **BFLG** |
|---|---|---|---|---|
| { 000...00 } | 0 | 0 | 0 | 0 |
| { 000...00 } | 0 | 0 | 1 | 0 |
| { 111...11 } | 0 | 1 | 0 | 0 |
| { 111...11 } | 0 | 1 | 1 | 0 |
| {000...00} | 1 | 0 | 0 | 0 |
| {111...11} | 1 | 0 | 1 | 0 |
| {111...11} | 1 | 1 | 0 | 0 |
| {000...00} | 1 | 1 | 1 | 0 |
| {010...10} | 0 | 0 | 0 | 1 |
| {010...10} | 0 | 0 | 1 | 1 |
| {101...01} | 0 | 1 | 0 | 1 |
| {101...01} | 0 | 1 | 1 | 1 |
| {010...10} | 1 | 0 | 0 | 1 |

(continued)

| DATAWR1 | S(2) | S(1) | S(0) | BFLG |
|---|---|---|---|---|
| {101...01} | 1 | 0 | 1 | 1 |
| {101...01} | 1 | 1 | 0 | 1 |
| {010...10} | 1 | 1 | 1 | 1 |

With reference to the previous table, it is possible showing that when the state bit S(2) is equal to "0" (march elements M0, M1, and first part of M2), the input data word DATAWR1 is equal to the expected data word DATAEXP1. Conversely, when the state bit S(2) is equal to "1" (the other part of march element M2 and all the march element M3), the input data word DATAWR1 is equal to the expected data word DATAEXP1 during writing operations (S(0)=0), otherwise (S(0)=1) it is the complement thereof. This particular inversion has been used because of the necessity to test WTFs during the march element M3.

**Claims**

1. A method for testing a memory device (100) comprising an arrangement of a plurality of memory elements (104), comprising:

   - defining a first and a second scanning sequences for scanning the memory elements;
   - defining at least one test datum ({XX});
   performing at least once a succession of operations including:

   a) writing the test datum into the plurality of memory elements, accessing thereto according to the first scanning sequence;
   b) accessing each memory element according to the first scanning sequence, reading a content (MOUT) thereof and comparing the read content to the test datum, and writing thereinto a complement of said test datum ({XX});
   c) accessing each memory element according to the second scanning sequence, reading a content thereof and comparing the read content to the complement of the test datum, and writing thereinto said test datum;
   d) accessing each memory element according to the second scanning sequence, reading a content thereof and comparing the read content to the test datum, writing thereinto said complement of the test datum, and reading again the content thereof and comparing the read content to the complement of the test datum.

2. The method according to claim 1, in which said arrangement of memory elements includes a two-dimensional arrangement (102) with a number of first lines (108) of memory elements and a number of second lines (110) of memory elements, and wherein each of the memory elements corresponds to a respective address (ADD) in a range from a lowest address to a highest address.

3. The method according to claim 2, in which each of said first and second scanning sequences includes repeatedly performing a first jump from a generic first memory element, belonging to a generic first one of the first lines and a generic first one of the second lines, to a generic second memory element, belonging to the same second line as the first generic memory element, and a second jump from said generic second memory element to a generic third memory element, belonging to the same first line as said generic first memory element, by varying an address of the generic first memory element.

4. The method according to claim 3, in which:

   for the first scanning sequence, said varying an address of the generic first memory element includes progressively increasing an address of the generic first element starting from the lowest-address memory element, and said generic third memory element corresponds to a successive address respect to the one of the generic first memory element; and
   for the second scanning sequence, said varying an address of the generic first memory element includes progressively decreasing an address of the generic first element starting from the highest-address memory element, and said generic third element corresponds to a preceding address respect to the one of the generic first memory element.

5. The method according to claim 4, further comprising:

for said first scanning sequence, when the generic first memory element corresponds to a last memory element of the generic first one of said first lines, performing, instead of said second jump, a third jump to a generic fourth memory belonging to the a generic second one of said first lines; and
for said second scanning sequence, when the generic first memory element corresponds to a first memory element of the generic first one of said first lines, performing, instead of said second jump, a fourth jump to a generic fourth memory belonging to the generic second one of said first lines.

6. The method according to claim 3, in which:

said performing the first jump for said first scanning sequence includes varying the address of an amount corresponding to half the number of memory elements, and for said second scanning sequence includes varying the address of an amount corresponding to the negative amount of half the number of memory elements; and
said performing the second jump for the first scanning sequence includes varying the address of an amount corresponding to one less half the number of memory elements, and for said second scanning sequence includes varying the address of an amount corresponding to half the number of memory elements less one.

7. The method according to any one of the preceding claims, comprising:

defining a second test datum; and
repeating the steps a) to d) executing writing and comparing operations using said second test datum and its complement.

8. A semiconductor memory comprising:

a memory matrix including a plurality of memory elements adapted to store data;
means for accessing (120,125) and writing (128) said plurality of memory elements;
a BIST circuit (415) for testing said memory device,

**characterized by** comprising:

means (505,510,515) adapted to generate a first and a second scanning sequences for scanning the memory elements;
means adapted to generate at least one test datum;
means adapted to command the means (520) for accessing and writing for performing at least once a succession of operation, including:.

a) writing the test datum into the plurality of memory elements, accessing thereto according to the first scanning sequence;
b) accessing each memory element according to the first scanning sequence, reading a content thereof (MOUT) and comparing the read content to the test datum by means of a comparator, and writing thereinto a complement of said test datum ({XX});
c) accessing each memory element according to the second scanning sequence, reading a content thereof and comparing the read content to the complement of the test datum by means of the comparator, and writing thereinto said test datum;
d) accessing each memory element according to the second scanning sequence, reading a content thereof and comparing the read content to the test datum by means of the comparator, writing thereinto said complement of the test datum, and reading again the content thereof and comparing the read content to the complement of the test datum by means of the comparator.

FIG.1

200

BEGIN

202 — SET {xx} = {000....00}    ] S1

204 — RESET ADD$_{(0)}$

206 — WRITE {xx}

208
ADD= C-1?    Y

210 — ⇑ INC. ADD    N

S2 [M0]

212 — RESET ADD$_{(0)}$

214 — READ AND COMPARE {xx}

216 — WRITE NOT ( {xx} )

218
ADD= C-1?    Y

218 — ⇑ INC. ADD    N

S3 [M1]

A

## FIG.2 (part 1)

FIG.2 (part 2)

SET {xx} = {010,....,10}    240

S6

S7  [M0]

S8  [M1]

S9  [M2]

S10  [M3]

END

FIG.2 (part 3)

## FIG.3A

ADD(15) ADD(14) ADD(13) ADD(12)

ADD(11) ADD(10) ADD(9) ADD(8)

ADD(7) ADD(6) ADD(5) ADD(4)

ADD(3) ADD(2) ADD(1) ADD(0)

102

## FIG.3B

ADD(15) ADD(14) ADD(13) ADD(12)

ADD(11) ADD(10) ADD(9) ADD(8)

ADD(7) ADD(6) ADD(5) ADD(4)

ADD(3) ADD(2) ADD(1) ADD(0)

102

FIG.4

FIG.5

FIG.6

705

0

1

1    T₁  Q₁

$\overline{Q_1}$

CK

710

712

714    716

T₂  Q₂          D₃  Q₃

$\overline{Q_2}$        $\overline{Q_3}$

CK          CK

510

00

01

10

11

ADD_EN

STEP

FIG.7A

CK

Q₁

$\overline{Q_3}$

FIG.7B

FIG.8

**FIG.9**

FIG.10

**European Patent Office**

**EUROPEAN SEARCH REPORT**

Application Number

EP 05 10 4183

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | VAN DE GOOR A J: "USING MARCH TESTS TO TEST SRAMS" IEEE DESIGN & TEST OF COMPUTERS, IEEE SERVICE CENTER, NEW YORK, NY, US, vol. 10, no. 1, 1 March 1993 (1993-03-01), pages 8-14, XP000360893 ISSN: 0740-7475 * the whole document * | 1-8 | G11C29/00 |
| X | DATABASE INSPEC [Online] THE INSTITUTION OF ELECTRICAL ENGINEERS, STEVENAGE, GB; 1996, VAN DE GOOR A J ET AL: "March LR: a test for realistic linked faults" XP002369786 Database accession no. 5391460 * abstract * & PROCEEDINGS OF 14TH VLSI TEST SYMPOSIUM 28 APRIL-1 MAY 1996 PRINCETON, NJ, USA, 1996, pages 272-280, Proceedings. 14th IEEE VLSI Test Symposium (Cat. No.96TB100043) IEEE Comput. Soc. Press Los Alamitos, CA, USA ISBN: 0-8186-7304-4 | 1-6 | |
| X | US 6 519 725 B1 (HUISMAN LEENDERT M ET AL) 11 February 2003 (2003-02-11) * figure 11 * | 1-6 | TECHNICAL FIELDS SEARCHED (IPC) G11C |
| A | RAJSUMAN R: "NEW ALGORITHM FOR TESTING RANDOM ACCESS MEMORIES" ELECTRONICS LETTERS, IEE STEVENAGE, GB, vol. 27, no. 7, 28 March 1991 (1991-03-28), pages 574-575, XP000227085 ISSN: 0013-5194 * the whole document * | 1-6 | |

The present search report has been drawn up for all claims

| Place of search | Date of completion of the search | Examiner |
|---|---|---|
| Munich | 27 February 2006 | Ríos Báez, A |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

## ANNEX TO THE EUROPEAN SEARCH REPORT
## ON EUROPEAN PATENT APPLICATION NO.

EP 05 10 4183

This annex lists the patent family members relating to the patent documents cited in the above-mentioned European search report.
The members are as contained in the European Patent Office EDP file on
The European Patent Office is in no way liable for these particulars which are merely given for the purpose of information.

27-02-2006

| Patent document cited in search report | | Publication date | Patent family member(s) | Publication date |
|---|---|---|---|---|
| US 6519725 | B1 | 11-02-2003 | NONE | |

EPO FORM P0459

For more details about this annex : see Official Journal of the European Patent Office, No. 12/82

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Non-patent literature cited in the description**

- **A.J. VAN DE GOOR.** Testing Semiconductors Memories - Theory and Practice. Wiley&Sons, 1991

- **MIKITJUK, V.G. ; YARMOLIK, V.N. ; VAN DE GOOR, A.J.** RAM Testing Algorithms for Detection Multiple Linked Faults. *Proc. Of the 1996 European Test Conference,* 1996